# EUROPÄISCHE PATENTSCHRIFT

(11) **EP 1 700 321 B1**
(45) Veröffentlichungstag und Bekanntmachung des Hinweises auf die Patenterteilung: **14.06.2017**
(21) Anmeldenummer: 04802646.2
(22) Anmeldetag: 26.10.2004
(51) Int. Cl.: H01L 33/48, H01L 33/58

(54) **OPTOELEKTRONISCHES MODUL UND VERFAHREN ZU DESSEN HERSTELLUNG**
OPTOELECTRONIC MODULE, AND METHOD FOR THE PRODUCTION THEREOF
MODULE OPTOELECTRONIQUE ET SON PROCEDE DE PRODUCTION

(30) Priorität: 30.12.2003 DE 10361650
(43) Veröffentlichungstag der Anmeldung: 13.09.2006
(73) Patentinhaber: OSRAM Opto Semiconductors GmbH, 93055 Regensburg (DE)
(72) Erfinder: BLÜMEL, Simon, 84069 Schierling (DE)
(74) Vertreter: Epping - Hermann - Fischer
(86) Internationale Anmeldenummer: PCT/DE2004/002385
(87) Internationale Veröffentlichungsnummer: WO 2005/064626

(56) Entgegenhaltungen:
- US-A- 4 168 102
- US-A- 5 153 734
- US-A- 5 920 120
- US-B1- 6 627 872
- PATENT ABSTRACTS OF JAPAN Bd. 011, Nr. 051 (E-480), 17. Februar 1987 (1987-02-17) -& JP 61 214566 A (TOSHIBA CORP), 24. September 1986 (1986-09-24)
- PATENT ABSTRACTS OF JAPAN Bd. 1998, Nr. 13, 30. November 1998 (1998-11-30) -& JP 10 222080 A (NIPPON COLUMBIA CO LTD), 21. August 1998 (1998-08-21)

## Beschreibung

Die Erfindung betrifft ein optoelektronisches Modul gemäß dem Oberbegriff von Patentanspruch 1 sowie ein Verfahren zum Herstellen eines optoelektronischen Moduls gemäß dem Oberbegriff von Patentanspruch 8.

Diese Patentanmeldung beansprucht die Priorität der deutschen Patentanmeldung 10361650.0, deren Offenbarungsgehalt hiermit durch Rückbezug aufgenommen wird.

Bei vielen Applikationen mit Halbleiterbauelementen zum Emittieren oder Detektieren von elektromagnetischer Strahlung werden zusätzliche optische Einrichtungen zur Formung dieser elektromagnetischen Strahlung verwendet. Dabei treten oft signifikante Verluste an Strahlungsintensität aufgrund von Reflexionen zwischen dem Halbleiterbauelement und der optischen Einrichtung auf. Dies betrifft insbesondere Reflexionen an Grenzflächen zwischen dem Halbleiterbauelement und der optischen Einrichtung.

Um derartige Reflexionen weitestgehend zu vermeiden ist es wichtig, die optische Einrichtung optisch möglichst gut mit dem Halbleiterbauelement zu verbinden, wozu insbesondere große Brechungsindexsprünge im Strahlengang zu vermeiden sind. Es ist bekannt, hierfür Gele mit einem entsprechend angepaßten Brechungsindex zu verwenden, mittels denen Zwischenräume im Strahlengang zwischen dem Halbleiterbauelement und der optischen Einrichtung ausgefüllt werden.

Ein Nachteil bei der Verwendung derartiger Gele ist, dass eine spezielle Fertigungstechnologie unter Verwendung von einer speziellen Dosieranlagen zum Aufbringen eines Geles notwendig ist, was einen deutlichen technischen Mehraufwand verursacht. Zudem sind Gele leicht irreversibel deformierbar und somit für viele nicht-statischen Anwendungen, bei denen es zu mechanischen Belastungen des Bauelementes wie Erschütterungen kommen kann, nur bedingt geeignet.

Aus der Druckschrift US 5,153,734 ist weiterhin ein Bauelement mit einem CCD-Chip und einem darüber angeordneten optischen Tiefpassfilter bekannt, die durch eine Halterung und eine Trägerplatte aufeinander gepresst werden. Durch ein Mylar-Plättchen zwischen dem CCD-Chip und dem optischen Tiefpassfilter, das eine Öffnung über der strahlungsdetektierenden Seite des CCD-Chips aufweist, wird ein direkter Kontakt zwischen dem CCD-Chip und dem optische Tiefpassfilter verhindert und gleichzeitig ein Staubschutz erreicht.

Ein Ziel der vorliegenden Erfindung ist, ein optoelektronisches Modul der eingangs genannten Art bereitzustellen, das eine verbesserte optische Verbindung zwischen dem Halbleiterbauelement und der optischen Einrichtung aufweist. Weiterhin soll ein einfaches und kostengünstiges Verfahren zur Herstellung eines derartigen optoelektronischen Moduls angegeben werden.

Diese Aufgaben werden mit einem optoelektronischen Modul gemäß Anspruch 1 beziehungsweise durch ein Verfahren gemäß Anspruch 8 gelöst. Bevorzugte Weiterbildungen und vorteilhafte Ausgestaltungen der Erfindung sind Gegenstand der abhängigen Ansprüche.

Erfindungsgemäß ist bei einem optoelektronischen Modul der eingangs genannten Art zwischen der Strahlungskoppelfläche und der optischen Einrichtung eine Verbindungsschicht aus einem strahlungsdurchlässigen, verformbaren Material angeordnet. Die optische Einrichtung und das Halbleiterbauelement sind derart relativ zueinander fixiert, dass sie gegeneinander gedrückt sind und dass die Verbindungsschicht dadurch derart gequetscht ist, dass sie eine Kraft erzeugt, die bestrebt ist die optische Einrichtung und die Strahlungskoppelfläche auseinander zu drücken.

Unter einer "Strahlungskoppelfläche" ist eine Strahlungsauskoppelfläche und/oder eine Strahlungseinkoppelfläche zu verstehen, d.h. eine Fläche des Halbleiterbauelements, über die Strahlung aus dem Halbleiterbauelement aus- oder in das Halbleiterbauelement eingekoppelt wird.

"Gegeneinander gedrückt" bedeutet im Zusammenhang der Erfindung, dass die optische Einrichtung und das Halbleiterbauelement, gegen die Kraft der Verbindungsschicht, durch eine Fixiereinrichtng dauerhaft in einem gegeneinander gedrückten Zustand gehalten sind, wodurch auf die Verbindungsschicht eine deformierende Kraft einwirkt.

Die Kraft der Verbindungsschicht wirkt der deformierenden Kraft entgegen. Bei Wegfallen der deformierenden Kraft, d.h. bei Wegfallen der relativen Fixierung von optischer Einrichtung und Halbleiterbauelement zueinander, bewirkt die Kraft der Verbindungsschicht, dass die optische Einrichtung und das Halbleiterbauelement auseinandergedrückt werden.

Die Verbindungsschicht ist derart beschaffen, dass durch sie erzeugte Kraft eine Bildung von Luftspalten zwischen der Verbindungsschicht und den angrenzenden Flächen weitestgehend vermieden wird. Dies gilt insbesondere für einen gesamten Betriebstemperaturbereich des Moduls sowie für eine Einwirkung zusätzlicher deformierender Kräfte auf die Verbindungsschicht, wie etwa Erschütterungen oder Fliehkräfte.

Die Verbindungsschicht besteht demnach insbesondere aus einem Material, das eine höhere Festigkeit aufweist als ein herkömmliches Gel und das über den gesamten Betriebstemperaturbereich des optoelektronischen Moduls nicht verfließbar ist.

Durch die Erfindung können Schwankungen eines Abstands zwischen dem Halbleiterbauelement und der optischen Einrichtung, die beispielsweise bei Temperaturschwankungen in Kombination mit Materialien des Halbleiterbauelementes und der optischen Einrichtung von unterschiedlichen Ausdehnungskoeffizienten auftreten können, wirkungsvoll ausgeglichen werden. Bei einer Vergrößerung des Abstandes etwa dehnt sich die zusammengedrückte Verbindungsschicht aus und minimiert somit das Risiko der Bildung eines Luftspaltes zwischen dem Halbleiterbauelement und der Strahlungskoppelfläche.

Die optische Einrichtung hat den Zweck, elektromagnetische Strahlung, die von dem Halbleiterbauelement emittiert oder empfangen wird, zumindest teilweise umzulenken. Sie kann etwa eine Linse zum Verdichten oder Aufweiten eines Kegels der elektromagnetischen Strahlung sein, oder z.B. auch ein Prisma.

In einer vorteilhaften Ausführungsform des optoelektronischen Moduls weist die Verbindungsschicht eine Mindestdicke von 30 *µ*m, bevorzugt von 100 *µ*m auf. Besonders bevorzugt weist die Verbindungsschicht eine Dicke von größer als oder gleich 150 *µ*m und kleiner als oder gleich 350 *µ*m auf. Eine derartige Dicke ist vorteilhaft damit das Halbleiterbauelement und die optische Einrichtung derart gegen die Verbindungsschicht gedrückt werden können, dass zwischen ihnen kein Luftspalt bleibt und die Verbindungsschicht eine ausreichend starke Kraft erzeugt, dass Abstandsschwankungen und Ausdehnungsunterschiede bestmöglich ausgeglichen werden können.

Die Verbindungsschicht weist bevorzugt einen Lack, besonders bevorzugt einen Platinenlack auf, wobei unter "Platinenlack" ein Lack zu verstehen ist, der sich als Schutzlack für Leiterplatten eignet. Im Gegensatz zu einer Verwendung eines Geles kann bei der Verwendung eines geeigneten Platinenlackes auf den Standardprozeß der Lackierung zurückgegriffen werden, wodurch sich der Fertigungsaufwand sowie die Fertigungskosten deutlich reduzieren lassen.

Bei einer weiteren vorteilhaften Ausführungsform ist eine Oberfläche des Trägerelementes zumindest teilweise zum Schutz vor äußeren Einflüssen mit einem Material beschichtet, das auch in der Verbindungsschicht enthalten ist. Zweckmäßigerweise kann hierfür ein geeigneter Platinenlack verwendet werden, das heißt der Platinenlack ist sowohl auf einer Oberfläche des Trägerelementes als auch zwischen dem Halbleiterbauelement und der optischen Einrichtung aufgebracht. Dadurch können Kosten eingespart werden, da durch eine Materialschicht zwei Funktionen erfüllt werden.

Ein Brechungsindex der Verbindungsschicht ist in einer besonders zweckmäßigen Ausführungsform des Moduls an einen Brechungsindex von einem an die Verbindungsschicht angrenzenden Material des Halbleiterbauelementes und/oder an einem Brechungsindex von einem an die Verbindungsschicht angrenzenden Material der optischen Einrichtung angepasst.

Die optische Einrichtung weist mit Vorteil refraktive und/oder reflektive Elemente auf.

Besonders bevorzugt ist das Halbleiterbauelement ein Lumineszenzdioden-Bauelement. Hierbei handelt es sich in einer vorteilhaften Ausführungsform um ein oberflächenmontierbares Halbleiterbauelement.

Bei einem Verfahren der eingangs genannten Art wird erfindungsgemäß vor dem Montieren der optischen Einrichtung eine aushärtbare und im ausgehärteten Zustand strahlungsdurchlässige und verformbare Masse zumindest über der Strahlungskoppelfläche des Halbleiterbauelementes aufgebracht. Nachfolgend wird die aufgebrachte Masse zumindest teilweise ausgehärtet oder aushärten gelassen. Die optische Einrichtung und das Halbleiterbauelement werden in einem weiteren Verfahrensschritt derart relativ zueinander fixiert, dass sie gegeneinander gedrückt sind und die Masse dadurch derart gequetscht ist, dass sie eine Kraft erzeugt, die bestrebt ist die optische Einrichtung und die Strahlungskoppelfläche auseinander zu drücken.

Bezüglich dem Ausdruck "gegeneinander gedrückt" gilt auch im Zusammenhang mit dem Verfahren das vorhergehend im Zusammenhang mit dem optoelektronischen Modul Ausgeführte. Das gleiche gilt für den Gegenstand der verformbaren Masse.

Die Masse wird zweckmäßigerweise in Form einer Schicht mit einer Mindestdicke von 30 *µ*m, bevorzugt von 100 *µ*m aufgebracht. Besonders bevorzugt wird die Masse in Form einer Schicht aufgebracht, die eine Dicke von größer als oder gleich 150 *µ*m und kleiner als oder gleich 350 *µ*m aufweist.

Die Masse weist bevorzugt einen Lack, besonders bevorzugt einen Platinenlack auf, der in einem ausgehärteten Zustand verformbar, beispielsweise weitestgehend elastisch verformbar ist. Wie weiter oben bereits erwähnt lässt sich ein Lack, insbesondere ein Platinenlack wesentlich kostengünstiger und mit wesentlich geringerem Aufwand aufbringen als etwa ein Gel.

In einer besonders zweckmäßigen Ausführungsform des Verfahrens wird die Masse zum Schutz vor äußeren Einflüssen zumindest auf einen Teil einer Oberfläche des Trägerelementes aufgebracht. Dies läßt sich mit einem Lack, insbesondere mit einem Platinenlack besonders zweckmäßig bewerkstelligen.

Das Aufbringen der Masse auf die Strahlungskoppelfläche und auf die Oberfläche des Trägerelementes erfolgt mit besonderem Vorteil in einem einzigen Verfahrensschritt.

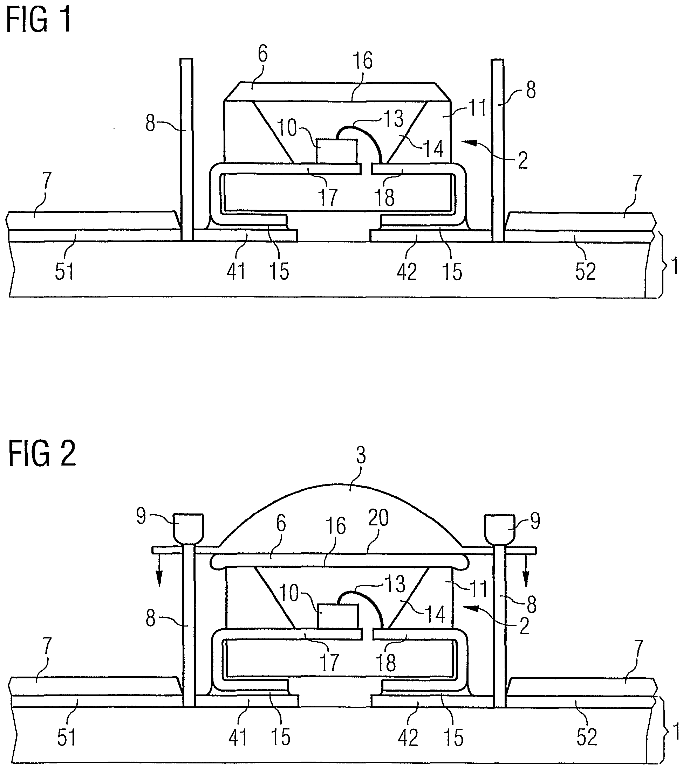

Weitere Merkmale, Vorteile und Zweckmäßigkeiten der Erfindung ergeben sich aus den im folgenden in Verbindung mit den Figuren 1 und 2 beschriebenen Ausführungsbeispielen. Es zeigen:
Figur 1 einen Ausschnitt einer schematischen Schnittansicht eines optoelektronischen Moduls bei einem Verfahrensstadium eines Ausführungsbeispiels des Verfahrens, und
Figur 2 einen Ausschnitt einer schematischen Schnittansicht eines Ausführungsbeispiels des optoelektronischen Moduls.

In den Ausführungsbeispielen und Figuren sind gleiche oder gleichwirkende Bestandteile jeweils mit den gleichen Bezugszeichen versehen. Die dargestellten Elemente der Figuren sind nicht als maßstabsgerecht anzusehen, vielmehr können sie zum besseren Verständnis teilweise übertrieben groß dargestellt sein.

Das in Figur 1 ausschnittsweise dargestellte optoelektronische Modul weist ein Trägerelement 1 auf, auf dem ein Halbleiterbauelement 2 aufgebracht ist. Das Trägerelement umfasst elektrische Anschlusselektroden 41, 42, an denen das Halbleiterbauelement 2 jeweils mit Gehäuseanschlussleitungen 17, 18 mittels einem Lot 15 elektrisch leitend angeschlossen ist.

Das Halbleiterbauelement ist beispielsweise ein Licht emittierendes Bauelement. Es weist einen Gehäusegrundkörper 11 auf, in den ein Leuchtdiodenchip 10 derart montiert ist, dass seine elektrischen Anschlussseiten elektrisch leitend mit den Gehäuseanschlussleitungen 17, 18 verbunden sind. Beispielsweise ist eine Rückseite des Leuchtdiodenchips 10 an einer ersten Gehäuseanschlussleitung 17 angelötet und eine Vorderseite mittels einem Bonddraht 13 mit einer zweiten Gehäuseanschlussleitung 18 elektrisch leitend verbunden. Der Leuchtdiodenchip 10 ist mit einer Vergussmasse 14 vergossen, deren von dem Gehäuse abgewandte Außenfläche eine Strahlungskoppelfläche 16 bildet, über die aus dem Halbleiterbauelement 2 bei dessen Betrieb erzeugtes Licht ausgekoppelt wird.

Alternativ kann das Halbleiterbauelement 2 beispielsweise auch ein Detektor für elektromagnetische Strahlung sein. In diesem Fall wird auf das Halbleiterbauelement 2 einfallende elektromagnetische Strahlung entsprechend an der Strahlungskoppelfläche 16 in das Halbleiterbauelement 2 eingekoppelt.

Derartige Halbleiterbauelemente sind dem Fachmann allgemein bekannt und werden von daher an dieser Stelle nicht weitergehend beschrieben.

Das optoelektronische Modul kann nur eines oder auch eine Mehrzahl derartiger Halbleiterbauelemente 2 zum Emittieren oder Detektieren von elektromagnetischer Strahlung aufweisen. Daneben können auch weitere, andersartige Bauelemente wie etwa Widerstände, Kondensatoren und/oder Induktivitäten auf dem Trägerelement 1 aufgebracht und/oder elektrisch leitend mit diesem verbunden sein.

Sowohl auf Teilen der Oberfläche des Trägerelementes 1 als auch auf der Strahlungskoppelfläche 16 des Halbleiterbauelementes 2 ist eine strahlungsdurchlässige, verformbare Masse in Form einer Schicht aufgebracht.

Auf der Oberfläche des Trägers dient diese Schicht als eine Schutzschicht 7 und kann dabei auch auf etwaig vorhandene, oben bereits erwähnte andersartige Bauelemente aufgebracht sein. Sie schützt die Oberfläche des Trägers und gegebenenfalls die andersartigen Bauelemente vor äußeren Einflüssen.

Auf der Oberfläche des Halbleiterbauelementes 2 dient die Schicht als eine Verbindungsschicht 6, mittels der das Halbleiterbauelement und eine optische Vorrichtung 3, die über der Strahlungskoppelfläche 16 angeordnet wird (siehe Figur 2), optisch miteinander verbunden werden können.

Die Schutzschicht 7 und die Verbindungsschicht 6 bestehen z.B. aus einem gleichen Material, beispielsweise aus einem geeigneten Platinenlack, und werden z.B. beide in einem einzigen Verfahrensschritt aufgebracht. Dadurch wird etwa durch einen Standardprozess der Platinenlackierung vorteilhafterweise ohne signifikanten Mehraufwand neben der Schutzschicht 7 gleichzeitig auch die Verbindungsschicht 6 erzeugt.

Ein geeigneter Platinenlack ist strahlungsdurchlässig, in gehärtetem Zustand verformbar und lässt sich zudem bevorzugt in einer ausreichend dicken Schicht aufbringen, damit sich das optisches Element 3 derart gegen die Verbindungsschicht 6 pressen lässt, dass sich die Verbindungsschicht verformt und dass kein Luftspalt zwischen dem optischen Element 3 und der Verbindungsschicht besteht.

Die Verbindungsschicht hat beispielsweise eine Dicke von 300 *µ*m und besteht z.B. aus einem Silikonlack. Hierzu ist etwa der Dickschichtlack DSL 1706 FLZ der Firma Lackwerke Peters GmbH & Co KG geeignet. Er basiert auf Polyorganosiloxan und weist eine schnelle Kondensationsvernetzung bei Raumtemperatur auf.

Für eine gute optische Verbindung von dem Halbleiterbauelement 2 und der optischen Einrichtung 3 ist der Brechungsindex des Materials der Verbindungsschicht 6 weitestgehend an die Brechungsindizes der Vergussmasse 14 und der optischen Einrichtung 3 angepasst, d.h. er ist ungefähr gleich diesen, oder, wenn sich die Brechungsindizes der Vergussmasse 14 und der optischen Einrichtung 3 deutlich voneinander unterscheiden, er liegt zwischen ihnen.

Nachdem die Verbindungsschicht 6 ausgehärtet ist, wird eine optische Einrichtung 3 derart über der Strahlungskoppelfläche 16 des Halbleiterbauelementes 2 montiert, dass die Verbindungsschicht 6 gequetscht wird. Hierzu weist das Trägerelement 1 beispielsweise zwei oder mehr senkrecht zu einer Haupterstreckungsebene des Trägerelementes 1 ragende Montierstäbe 8 mit einem Gewinde auf.

Die optische Einrichtung 3 ist z.B. eine optische Konvexlinse mit seitlichen Verlängerungen, in die Löcher eingebracht sind. die optische Einrichtung wird derart montiert, dass die Montierstäbe 8 durch die Löcher geführt werden. Nachfolgend wird die optische Einrichtung mittels Muttern 9 fixiert, so dass sie gegen die Verbindungsschicht gedrückt ist, was in Figur durch Pfeile an der optischen Einrichtung angedeutet ist. Dadurch ist die Verbindungsschicht zusammengedrückt bzw. zusammengequetscht. Im verformten Zustand ist die Verbindungsschicht 6 zudem in ihrer Haupterstreckungsebene etwas auseinandergepresst (vergleiche Figur 1 mit Figur 2).

Die optische Einrichtung kann alternativ zu der in Figur 2 dargestellten Linse refraktive und/oder reflektive Elemente aufweisen.

Zudem ist es möglich, die Verbindungsschicht auch auf die dem Halbleiterbauelement zugewandte Seite 20 der optischen Einrichtung 3 aufzubringen und die optische Einrichtung zusammen mit der Verbindungsschicht 6 über der Strahlungskoppelfläche 16 zu montieren. Es ist jedoch bevorzugt, die Verbindungsschicht 6 zunächst über der Strahlungskoppelfläche 16 aufzubringen und nachfolgend erst die optische Einrichtung 3 über der Verbindungsschicht 6 zu montieren.

Zwischen der Verbindungsschicht 6 und der Strahlungskoppelfläche 16 oder der optischen Einrichtung 3 können noch weitere Elemente angeordnet sein, d.h. die Verbindungsschicht muß nicht zwingend direkt an die Strahlungskoppelfläche 16 oder die optische Einrichtung 3 anschließen.

Der Schutzumfang der Erfindung ist nicht durch die Beschreibung der Erfindung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn diese Kombination nicht explizit in den Patentansprüchen angegeben ist.

## Patentansprüche

1. Optoelektronisches Modul, umfassend:
- ein Trägerelement (1), das elektrische Anschlusselektroden (41, 42) und elektrische Leitungen aufweist,
- mindestens ein auf dem Trägerelement (1) aufgebrachtes und an Anschlusselektroden (41, 42) des Trägerelementes (1) elektrisch angeschlossenes Halbleiterbauelement (2) zum Emittieren oder Detektieren von elektromagnetischer Strahlung, das eine Strahlungskoppelfläche (16) aufweist, und
- mindestens eine optische Einrichtung (3), die dem Halbleiterbauelement (2) zugeordnet ist, wobei in einem Spalt zwischen der Strahlungskoppelfläche (16) und der optischen Einrichtung (3) eine Verbindungsschicht (6) aus einem strahlungsdurchlässigen, verformbaren Material angeordnet ist, wobei die optische Einrichtung (3) und das Halbleiterbauelement (2) derart relativ zueinander fixiert sind, dass sie gegeneinander gedrückt sind und dass die Verbindungsschicht (6) dadurch derart gequetscht ist, dass sie eine Kraft erzeugt, die bestrebt ist die optische Einrichtung (3) und die Strahlungskoppelfläche (16) auseinander zu drücken,
**dadurch gekennzeichnet, dass** die Verbindungsschicht (6) einen Lack aufweist, der in einem ausgehärteten Zustand verformbar ist, und/oder eine Oberfläche des Trägerelementes (1) zumindest teilweise zum Schutz vor äußeren Einflüssen mit einem Material beschichtet ist, das auch in der Verbindungsschicht (6) enthalten ist, und/oder ein Brechungsindex der Verbindungsschicht (6) an einen Brechungsindex von einem an die Verbindungsschicht (6) angrenzenden Material des Halbleiterbauelementes (2) und/oder an einen Brechungsindex von einem an die Verbindungsschicht (6) angrenzenden Material der optischen Einrichtung (3) angepasst ist.

2. Optoelektronisches Modul nach Anspruch 1,
**dadurch gekennzeichnet,**
**dass** die Verbindungsschicht (6) eine Dicke von mindestens 30 µm, bevorzugt von mindestens 100 µm aufweist.

3. Optoelektronisches Modul nach Anspruch 2,
**dadurch gekennzeichnet,**
**dass** die Verbindungsschicht (6) eine Dicke von größer als oder gleich 150 µm und kleiner als oder gleich 350 µm aufweist.

4. Optoelektronisches Modul nach einem der vorhergehenden Ansprüche,
**dadurch gekennzeichnet,**
**dass** der Lack ein Platinenlack ist.

5. Optoelektronisches Modul nach einem der vorhergehenden Ansprüche,
**dadurch gekennzeichnet,**
**dass** die optische Einrichtung (3) refraktive und/oder reflektive Elemente aufweist.

6. Optoelektronisches Modul nach einem der vorhergehenden Ansprüche,
**dadurch gekennzeichnet,**
**dass** das Halbleiterbauelement (2) ein Lumineszenzdioden-Bauelement ist.

7. Optoelektronisches Modul nach einem der vorhergehenden Ansprüche,
**dadurch gekennzeichnet,**
**dass** das Halbleiterbauelement (2) ein oberflächenmontierbares Bauelement ist.

8. Verfahren zum Herstellen eines optoelektronischen Moduls mit mindestens den Verfahrensschritten:
- Bereitstellen
- eines Trägerelementes (1), das elektrische Anschlußelektroden (41, 42) und elektrische Leitungen aufweist,
- eines Halbleiterbauelementes (2) zum Emittieren oder Detektieren von elektromagnetischer Strahlung, das eine Strahlungskoppelfläche (16) aufweist, und
- einer optischen Einrichtung (3),
- Aufbringen des Halbleiterbauelementes (2) auf dem Trägerelement (1) und elektrisches Anschließen des Halbleiterbauelementes (2) an die Anschlußelektroden (41, 42), und
- Montieren der optischen Einrichtung (3) überhalb der Strahlungskoppelfläche (16) des Halbleiterbauelements (2), wobei
- vor dem Montieren der optischen Einrichtung (3) eine aushärtbare und im ausgehärteten Zustand strahlungsdurchlässige und verformbare Masse zumindest über der Strahlungskoppelfläche (16) des Halbleiterbauelements (2) aufgebracht wird,
- die aufgebrachte Masse zumindest teilweise ausgehärtet wird oder Aushärten gelassen wird, und
- die optische Einrichtung (3) und das Halbleiterbauelement (2) derart relativ zueinander fixiert werden, dass sie gegeneinander gedrückt sind und die Masse, die eine Verbindungsschicht (6) bildet, dadurch derart gequetscht ist, dass sie eine Kraft erzeugt, die bestrebt ist die optische Einrichtung (3) und die Strahlungskoppelfläche (16) auseinander zu drücken, und
- die Masse einen Lack aufweist, der in einem ausgehärteten Zustand verformbar ist, und/oder die Masse zum Schutz vor äußeren Einflüssen zumindest auf einen Teil einer Oberfläche des Trägerelementes (1) aufgebracht wird und/oder ein Brechungsindex der Verbindungsschicht (6) an einen Brechungsindex von einem an die Verbindungsschicht (6) angrenzenden Material des Halbleiterbauelementes (2) und/oder an einen Brechungsindex von einem an die Verbindungsschicht (6) angrenzenden Material der optischen Einrichtung (3) angepasst ist.

9. Verfahren nach Anspruch 8,
**dadurch gekennzeichnet,**
**dass** die Masse in Form einer Schicht aufgebracht wird, die eine Dicke von mindestens 30 µm, bevorzugt von mindestens 100 µm aufweist.

10. Verfahren nach Anspruch 9,
**dadurch gekennzeichnet,**
**dass** die Masse in Form einer Schicht aufgebracht wird, die eine Dicke von größer als oder gleich 150 µm und kleiner als oder gleich 350 µm aufweist.

11. Verfahren nach einem der Ansprüche 8 bis 10,
**dadurch gekennzeichnet,**
**dass** der Lack ein Platinenlack ist.

12. Verfahren nach einem der Ansprüche 8 bis 11,
**dadurch gekennzeichnet,**
**dass** das Aufbringen der Masse auf die Strahlungskoppelfläche (16) und auf die Oberfläche des Trägerelementes (1) in einem einzigen Verfahrensschritt erfolgt.

## Claims

1. Optoelectronic module, comprising:
- a carrier element (1) having electrical connection electrodes (41, 42) and electrical lines,
- at least one semiconductor component (2) for emitting or detecting electromagnetic radiation, said semiconductor component being applied on the carrier element (1) and being electrically connected to connection electrodes (41, 42) of the carrier element (1) and having a radiation coupling area (16), and
- at least one optical device (3) assigned to the semiconductor component (2),
wherein
a connecting layer (6) made of a radiation-transmissive, deformable material is arranged in a gap between the radiation coupling area (16) and the optical device (3), the optical device (3) and the semiconductor component (2) being fixed relative to one another in such a way that they are pressed against one another and that the connecting layer (6) is thereby squeezed in such a way that it generates a force that strives to press the optical device (3) and the radiation coupling area (16) apart,
**characterized in that** the connecting layer (6) has a lacquer which is deformable in a cured state, and/or a surface of the carrier element (1) is at least partly coated for protection against external influences with a material that is also contained in the connecting layer (6), and/or a refractive index of the connecting layer (6) is adapted to a refractive index of a material of the semiconductor component (2) that adjoins the connecting layer (6) and/or to a refractive index of a material of the optical device (3) that adjoins the connecting layer (6).

2. Optoelectronic module according to Claim 1,
**characterized**
**in that** the connecting layer (6) has a thickness of at least 30 µm, preferably of at least 100 µm.

3. Optoelectronic module according to Claim 2,
**characterized**
**in that** the connecting layer (6) has a thickness of greater than or equal to 150 µm and less than or equal to 350 µm.

4. Optoelectronic module according to one of the preceding claims,
**characterized**
**in that** the lacquer is a circuit board lacquer.

5. Optoelectronic module according to one of the preceding claims,
**characterized**
**in that** the optical device (3) has refractive and/or reflective elements.

6. Optoelectronic module according to one of the preceding claims,
**characterized**
**in that** the semiconductor component (2) is a luminescence diode component.

7. Optoelectronic module according to one of the preceding claims,
**characterized**
**in that** the semiconductor component (2) is a surface-mountable component.

8. Method for producing an optoelectronic module having at least the method steps of:
- providing
- a carrier element (1) having electrical connection electrodes (41, 42) and electrical lines,
- a semiconductor component (2) for emitting or detecting electromagnetic radiation, said semiconductor component having a radiation coupling area (16), and
- an optical device (3),
- applying the semiconductor component (2) on the carrier element (1) and electrically connecting the semiconductor component (2) to the connection electrodes (41, 42), and
- mounting the optical device (3) above the radiation coupling area (16) of the semiconductor component (2),
wherein,
- prior to mounting the optical device (3), a curable and, in the cured state, radiation-transmissive and deformable composition is applied at least over the radiation coupling area (16) of the semiconductor component (2),
- the applied composition is at least partly cured or caused to be cured, and
- the optical device (3) and the semiconductor component (2) are fixed relative to one another in such a way that they are pressed against one another and the composition, which forms a connecting layer (6), is thereby squeezed in such a way that it generates a force that strives to press the optical device (3) and the radiation coupling area (16) apart, and
- the composition has a lacquer which is deformable in a cured state, and/or the composition is applied at least to part of a surface of the carrier element (1) for protection against external influences and/or a refractive index of a material of the semiconductor component (2) that adjoins the connecting layer (6) and/or to a refractive index of a material of the optical device (3) that adjoins the connecting layer (6).

9. Method according to Claim 8,
**characterized**
**in that** the composition is applied in the form of a layer having a thickness of at least 30 µm, preferably of at least 100 µm.

10. Method according to Claim 9,
**characterized**
**in that** the composition is applied in the form of a layer having a thickness of greater than or equal to 150 µm and less than or equal to 350 µm.

11. Method according to one of Claims 8 to 10,
**characterized**
**in that** the lacquer is a circuit board lacquer.

12. Method according to one of Claims 8 to 11,
**characterized**
**in that** the composition is applied to the radiation coupling area (16) and to the surface of the carrier element (1) in a single method step.

## Revendications

1. Module optoélectronique, comprenant :
- un élément de support (1) qui présente des électrodes de connexion (41, 42) électriques et des lignes électriques ;
- au moins un élément à semi-conducteurs (2) raccordé électriquement à des électrodes de connexion (41, 42) de l'élément de support (1) et mis en place sur l'élément de support (1), ledit au moins un élément à semi-conducteurs étant destiné à la transmission ou à la détection d'un rayonnement électromagnétique et présente une surface de couplage de rayonnement (16) ; et
- au moins un mécanisme optique (3) qui est associé à l'élément à semi-conducteurs (2),
selon lequel une couche de liaison (6) constituée d'un matériau ductile et perméable au rayonnement est disposée dans une fente se trouvant entre la surface de couplage de rayonnement (16) et le mécanisme optique (3), selon lequel le mécanisme optique (3) et l'élément à semi-conducteurs (2) sont bloqués de telle sorte l'un par rapport à l'autre qu'ils sont comprimés l'un contre l'autre et de telle sorte que la couche de liaison (6) est écrasée de telle sorte qu'elle produit une force qui tend à écarter l'un de l'autre le mécanisme optique (3) et la surface de couplage de rayonnement (16), **caractérisé en ce que**
la couche de liaison (6) présente une laque qui est ductile dans un état durci et/ou une surface de l'élément de support (1) est pourvue, tout au moins en partie, d'un revêtement destiné à la protection contre les extérieures influences et constitué d'un matériau qui est également contenu dans la couche de liaison (6) et/ou un indice de réfraction de la couche de liaison (6) est adapté à un indice de réfraction d'un matériau de l'élément à semi-conducteur (2), lequel matériau est adjacent à la couche de liaison (6), et/ou est adapté à un indice de réfraction d'un matériau du mécanisme optique (3), lequel matériau est adjacent à la couche de liaison (6).

2. Module optoélectronique selon la revendication 1,
**caractérisé en ce que**
la couche de liaison (6) présente une épaisseur d'au moins 30 µm, de préférence d'au moins 100 µm.

3. Module optoélectronique selon la revendication 2,
**caractérisé en ce que**
la couche de liaison (6) présente une épaisseur supérieure ou égale à 150 µm et inférieure ou égale à 350 µm.

4. Module optoélectronique selon l'une des revendications précédentes,
**caractérisé en ce que**
la laque est une laque platinifère.

5. Module optoélectronique selon l'une des revendications précédentes,
**caractérisé en ce que**
le mécanisme optique (3) présente des éléments de réfraction et/ou de réflexion.

6. Module optoélectronique selon l'une des revendications précédentes,
**caractérisé en ce que**
l'élément à semi-conducteurs (2) est un élément structurel à diodes électroluminescentes.

7. Module optoélectronique selon l'une des revendications précédentes,
**caractérisé en ce que**
l'élément à semi-conducteurs (2) est un élément structurel pouvant être monté sur une surface.

8. Procédé destiné à la fabrication d'un module optoélectronique, comprenant au moins les phases de procédé suivantes :
- la mise en oeuvre d'un élément de support (1) qui présente des électrodes de connexion (41, 42) électriques et des lignes électriques ;
- la mise en oeuvre d'un élément à semi-conducteurs (2) destiné à la transmission ou à la détection d'un rayonnement électromagnétique qui présente une surface de couplage de rayonnement (16) ; et
- la mise en oeuvre d'un mécanisme optique (3) ; et
- la mise en place de l'élément à semi-conducteurs (2) sur l'élément de support (1) et le raccordement électrique de l'élément à semi-conducteurs (2) aux électrodes de connexion (41, 42) ; et
- le montage du mécanisme optique (3) au-dessus de la surface de couplage de rayonnement (16) de l'élément à semi-conducteurs (2),
selon lequel
- une masse ductile, durcissable et perméable au rayonnement à l'état durci est mise en place avant le montage du mécanisme optique (3), tout au moins au-dessus de la surface de couplage de rayonnement (16) de l'élément à semi-conducteurs (2) ;
- la masse mise en place est durcie ou est mise à durcir, tout au moins en partie ; et
- le mécanisme optique (3) et l'élément à semi-conducteurs (2) sont bloqués de telle sorte l'un par rapport à l'autre qu'ils sont comprimés l'un contre l'autre et la masse qui forme une couche de liaison (6) est écrasée de telle sorte qu'elle produit une force qui tend à écarter le mécanisme optique (3) et la surface de couplage de rayonnement (16) l'un de l'autre et
- la masse présente une laque qui est ductile dans un état durci et/ou la masse destinée à la protection contre les influences extérieures est mise en place tout au moins sur une partie d'une surface de l'élément de support (1) et/ou un indice de réfraction de la couche de liaison (6) est adapté à un indice de réfraction d'un matériau de l'élément à semi-conducteurs (2), lequel matériau est adjacent à la couche de liaison (6), et/ou est adapté à un indice de réfraction d'un matériau du mécanisme optique (3), lequel matériau est adjacent à la couche de liaison (6).

9. Procédé selon la revendication 8,
**caractérisé en ce que**
la masse est mise en place sous la forme d'une couche, laquelle présente une épaisseur d'au moins 30 µm, de préférence d'au moins 100 µm.

10. Procédé selon la revendication 9,
**caractérisé en ce que**
la masse est mise en place sous la forme d'une couche, laquelle présente une épaisseur supérieure ou égale à 150 µm et inférieure ou égale à 350 µm.

11. Procédé selon l'une des revendications 8 à 10,
**caractérisé en ce que**
la laque est une laque platinifère.

12. Procédé selon l'une des revendications 8 à 11,
**caractérisé en ce que**
la mise en place de la masse sur la surface de couplage de rayonnement (16) et sur la surface de l'élément de support (1) est réalisée lors d'une seule phase de procédé.
